Europäisches Patentamt

European Patent Office

Office européen des brevets

(11) Veröffentlichungsnummer: 0 404 248
A2

# (12) EUROPÄISCHE PATENTANMELDUNG

(21) Anmeldenummer: 90201578.3

(22) Anmeldetag: 18.06.90

(51) Int. Cl.⁵: G01R 33/48

(30) Priorität: 22.06.89 DE 3920433

(43) Veröffentlichungstag der Anmeldung:
27.12.90 Patentblatt 90/52

(84) Benannte Vertragsstaaten:
DE FR GB

(71) Anmelder: Philips Patentverwaltung GmbH
Wendenstrasse 35 Postfach 10 51 49
D-2000 Hamburg 1(DE)

㊹ DE

Anmelder: N.V. Philips' Gloeilampenfabrieken

Groenewoudseweg 1
NL-5621 BA Eindhoven(NL)

㊹ FR GB

(72) Erfinder: Wieland, Jürgen, Dr.
Am Hang 17
D-2080 Pinneberg(DE)

(74) Vertreter: Hartmann, Heinrich, Dipl.-Ing. et al
Philips Patentverwaltung GmbH
Wendenstrasse 35 Postfach 10 51 49
D-2000 Hamburg 1(DE)

(54) **Kernresonanzabbildungsverfahren.**

㊚ Die Erfindung betrifft ein Verfahren zur Darstellung der Milchsäureverteilung in einer Schicht. Dabei werden erste und zweite Sequenzen mit je mindestens drei Hochfrequenzimpulsen erzeugt, wobei die erste Sequenz so gestaltet ist, daß das resultierende stimulierte Echosignal von den Milchsäurekomponenten unbeeinflußt bleibt, während die zweite Sequenz so gestaltet ist, daß das stimulierte Echosignal (auch) von der Milchsäurekomponente bestimmt wird. Durch Subtraktion der beiden stimulierten Echosignale und Wiederholung dieser Sequenzen mit nach Größe und/oder Errichtung variierenden Codierungsgradienten läßt sich ein Satz von Differenzsignalen erzeugen, aus dem durch zweidimensionale Fouriertransformation die gewünschte Verteilung ermittelt werden kann.

EP 0 404 248 A2

Fig.4

Die Erfindung betrifft ein Kernresonanzabbildungsverfahren. Aus der DE-OS 34 45 689 ist ein solches Verfahren bekannt, bei dem in Anwesenheit eines homogenen stationären Magnetfeldes eine Vielzahl von Sequenz auf einen Untersuchungsbereich einwirkt. Jede Sequenz umfaßt drei Hochfrequenzimpulse, von denen einer schichtselektiv ist. Von Sequenz zu Sequenz wird dabei die Amplitude eines magnetischen Gradientenfeldes - des sogenannten Phasencodierungsgradienten - variiert. Aus den auf diese Weise gewonnenen stimulierten Echosignalen läßt sich mit Hilfe einer zweidimensionalen Fouriertransformation die Kernmagnetisierungsverteilung in der durch den schichtselektiven Hochfrequenzimpuls angeregten Schicht rekonstruieren. Die auf diese Weise erzeugte Abbildung wird im wesentlichen durch die an Wasserstoff gebundenen Protonen bestimmt. Die an Fett (Lipide) oder an Milchsäure gebundenen Protonen beeinflussen die Abbildung zwar auch, doch ist dieser Einfluß wegen der geringen Konzentration dieser Komponenten außerordentlich gering.

Es hat sich in jüngster Zeit herausgestellt, daß die Substanz Milchsäure (Laktat) ein wesentlicher Metabolit von Tumoren ist, so daß sie zu deren Identifikation herangezogen werden kann. Aufgabe der vorliegenden Erfindung ist daher die Schaffung eines Verfahrens, mit dem die räumliche Verteilung von Milchsäure bestimmt werden kann.

Gelöst wird diese Aufgabe durch ein Verfahren mit den folgenden Schritten:

a) Erzeugung einer ersten Sequenz mit drei Hochfrequenzimpulsen, von denen mindestens einer schichtselektiv ist, wobei zwischen dem ersten und dem zweiten Hochfrequenzimpuls sowie nach dem dritten Hochfrequenzimpuls und vor der Erfassung des Kernresonanzsignals ein magnetisches Gradientenfeld mit jeweils dem gleichen zeitlichen Integral wirksam wird und wobei der zeitliche Abstand zwischen dem ersten und dem zweiten Hochfrequenzimpuls 1/2 J ist, wobei J die Kopplungskonstante von Milchsäure ist,

b) Erzeugung einer zweiten Sequenz, die sich von der ersten nur dadurch unterscheidet, daß zusätzlich zwei 180˚-Hochfrequenzimpulse im jeweils gleichen Abstand von dem ersten bzw. dem dritten Hochfrequenzimpuls erzeugt werden, wobei der eine 180˚-Hochfrequenzimpuls in der Mitte zwischen dem ersten und dem zweiten Hochfrequenzimpuls liegt und wobei beide 180˚-Hochfrequenzimpulse derart frequenzselektiv sind, daß nur eine der beiden gekoppelten Milchsäurekomponenten angeregt wird,

c) Erfassung der bei jeder Sequenz auftretenden stimulierten Echosignale

d) Wiederholung der Schritte a) bis c) unter Variation wenigstens eines magnetischen Gradientenfeldes nach Größe und/oder Richtung

e) Bildung der Differenz zwischen den stimulierten Echosignalen und der ersten und der zweiten Sequenzen

f) Rekonstruktion der Milchsäureverteilung in der angeregten Schicht aus den Differenzen.

Die Erfindung nutzt die Tatsache aus, daß die Resonanzlinien der gekoppelten Lipidkomponenten relativ dicht beieinander sowie bei einer der beiden gekoppelten Milchsäurekomponenten liegen; die andere Milchsäurekomponente liegt in der Nähe der Resonanzlinie von Wasser. Die von den Hochfrequenzimpulsen erfaßten Lipidkomponenten - gekoppelt und ungekoppelt - tragen in jeder Sequenz zu dem dadurch erzeugten stimulierten Echosignal bei, so daß bei der Differenzbildung zwischen den stimulierten Signalen der ersten und der zweiten Sequenz der Einfluß dieser Komponenten eliminiert wird.

Wenn der Polarisationstransfer von der dem Wasser frequenzmäßig benachbarten Milchsäurekomponente auf die andere Milchsäurekomponente unterbunden ist (z.B. dadurch, daß die erstgenannte Komponente - zusammen mit der Wasserkomponente - von vornherein unterdrückt wird oder dadurch, daß zwei der drei Hochfrequenzimpulse frequenzselektiv sind und nur die andere Milchsäurekomponente anregen), verschwindet die Anregungsenergie der anderen Komponente (durch Polarisationstransfer und durch Entstehen höherer nicht beobachtbarer Quantenzustände) bei der ersten Sequenz, so daß diese Milchsäurekomponente auf das dabei auftretende stimulierte Echosignal keinen Einfluß hat. Bei der zweiten Sequenz wird jedoch durch den genau in der Mitte zwischen dem ersten und dem zweiten Hochfrequenzimpuls befindlichen 180˚-Impuls und durch den auf den letzten der drei Hochfrequenzimpulse folgenden 180˚-Hochfrequenzimpuls die durch die J-Kopplung bewirkte Modulation dieser Milchsäurekomponente refokussiert, so daß bei der zweiten Sequenz die erwähnte Milchsäurekomponente einen Beitrag zu dem stimulierten Echosignal liefert. Bildet man demgemäß die Differenz zwischen den stimulierten Echosignalen der ersten und der zweiten Sequenz, dann ergibt sich ein Signal, das im wesentlichen nur durch diese Milchsäurekomponente bestimmt wird.

Eine Anordnung zur Durchführung des Verfahrens ist versehen mit einem Magneten zur Erzeugung eines homogenen stationären Magnetfeldes und mit Mitteln zum wiederholten Erzeugen der ersten und der zweiten Sequenz, mit Mitteln zum Erfassen der bei den einzelnen Sequenzen erzeugten stimulierten Echosignale, mit Mitteln zur Bildung der Differenz der stimulierten Echosignale und zur Rekonstruktion der Milchsäureverteilung aus den Differenzen.

Die Erfindung wird nachstehend anhand der Zeichnung näher erläutert. Es zeigen

Fig. 1 ein Kernspintomographiegerät, mit dem das erfindungsgemäße Verfahren durchführbar ist.

Fig. 2 ein Blockschaltbild eines solchen Gerätes.

Fig. 3 die Lage der Spektralkomponenten von Wasser, Milchsäure und Lipiden und

Fig. 4 den zeitlichen Verlauf der erfindungsgemäßen Sequenzen.

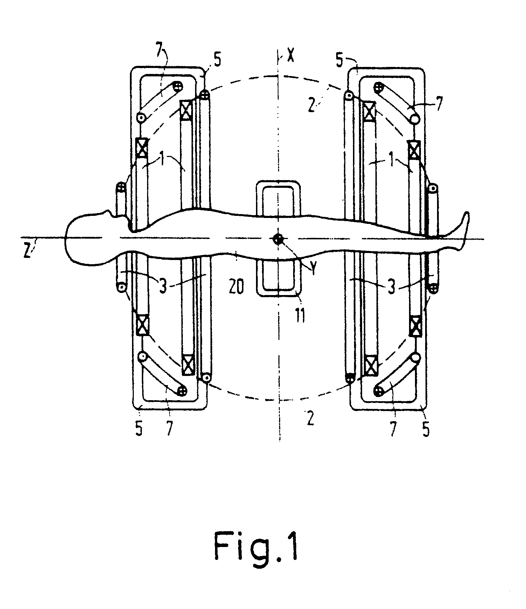

Das in Fig. 1 schematisch dargestellte Kernspin-Untersuchungsgerät enthält eine aus vier Spulen 1 bestehende Anordnung zur Erzeugung eines homogenen stationären Magnetfeldes, das ausreichend stark sein muß und z.B. 4 Tesla beträgt. Dieses Feld verläuft in z-Richtung eines kartesischen Koordinatensystems. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Figur 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochdrequenter modulierter Strom von einem Hochfrequenzgenerator zugeführt. Im Anschluß an eine Sequenz dient die Hochfrequenzspule 11 oder eine gesonderte Hochfrequenz-Empfangsspule zum Empfangen der im Untersuchungsbereich erzeugten Kernresonanzsignale.

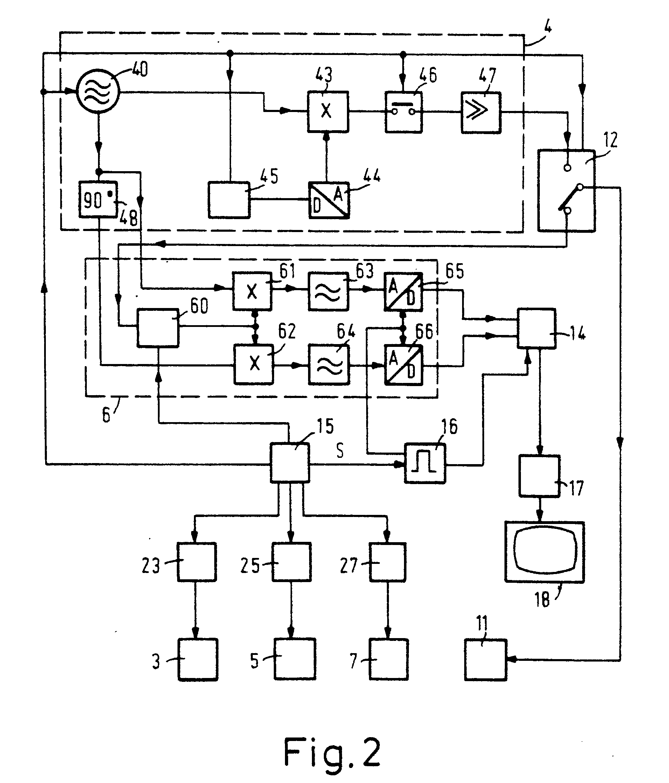

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der mischstufe wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung -eine Folge von ein Hüllkurvensignal darstellenden digitalen Datenworten ausgelesen.

Die Mischstufe 43 verarbeitet die ihr zugeführten Eingangssignale so, daß sie an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multipli kativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall diec von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte werden einem Rechner 17 zugeführt, der daraus das Spektrum der Kernmagnetisierung ermittelt und an einer geeigneten Wiedergabeeinheit, z.B. einem Monitor 18, ausgibt.

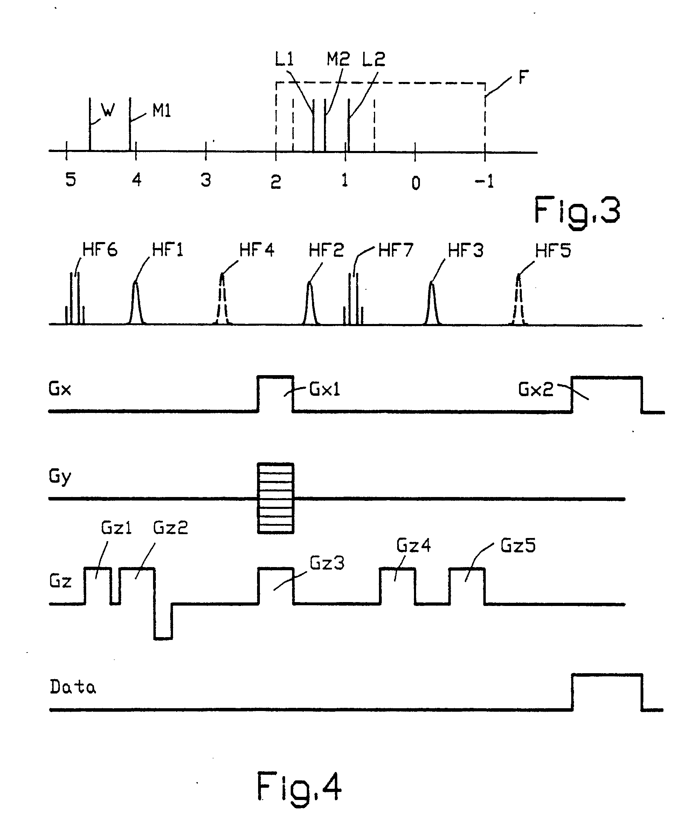

Fig. 3 zeigt die Lage der für die klinische Untersuchung wesentlichen Komponenten auf einer Frequenzskala, die die auf die Larmorfrequenz von TMS (Tetramethylsilan) normierte Frequenzabweichung gegenüber der Larmorfrequenz von TMS angibt. Die Larmorfrequenz von TMS liegt dabei also bei Null, während die Larmorfrequenz W von Wasser bei 4,7 ppm liegt. Die beiden miteinander gekoppelten Komponenten M1 und M2 der $CH_3$-Gruppe von Milchsäure bzw. Laktat liegen bei 4,1 ppm bzw. bei 1,3 ppm, während die entsprechenden Komponenten L1 und L2 der Lipide bei 1,4 und 0,9 liegen.

Der zeitliche Verlauf einer Sequenz ergibt sich aus Fig. 4, deren erste Zeile die zeitliche Lage der Hochfrequenzimpulse darstellt. Jede Sequenz umfaßt die drei Hochfrequenzimpulse HF1, HF2, HF3, vorzugsweise 90°-Impulse. Von diesen drei Hochfrequenzimpulsen ist einer schichtselektiv, vorzugsweise der erste. Die beiden anderen sind vorzugsweise frequenzselektiv. Die frequenzselektiven Hochfrequenzimpulse haben eine derart geringe Bandbreite, daß von dem in Fig. 3 dargestellten Spektrum nur die Milchsäurekomponente M2, die Lipidkomponenten L1, L2 sowie einige ungekoppelte Lipidkomponenten angeregt werden, nicht aber die Laktatkomponente M1 und die Wasserkomponente W. Das durch geeignete Gestaltung des aus dem Speicher 45 entnommenen Hüllkurvensignals nahezu rechteckförmige Frequenzspektrum dieser Hochfrequenzimpulse ist in Fig. 3 mit F angedeutet. Man erkennt, daß das Spektrum, das seine Mittenfrequenz bei 0,5 ppm hat und von -1 ppm bis +2 ppm erreicht, unsymmetrisch zu den anzuregenden Frequenzkomponenten (L1, M2, L2) liegt. Würde man stattdessen das Spektrum F symmetrisch zu den erwähnten Komponenten legen, dann müßten - bei gleichbleibender oberer Grenzfrequenz - die Hochfrequenzimpulse noch schmalbandiger sein und damit noch länger dauern.

Bei der in Fig. 4 dargestellten Sequenz wirkt der erste Hochfrequenzimpuls HF1 schichtselektiv, weil während seiner Dauer ein magnetisches Gradientenfeld Gz2 wirksam ist (4. Zeile von Fig. 4). Die Hochfrequenzimpulse HF2 und HF3 sind frequenzselektiv und besitzen das Anregungsspektrum F (Fig. 3). Der erste Hochfrequenzimpuls HF1 regt innerhalb der Schicht nicht nur die Frequenzkomponenten im Spektralbereich F an, sondern auch die außerhalb liegenden Frequenzkomponenten, beispielsweise W und M1. Das durch diesen Hochfrequenzimpuls erzeugte FID-Signal, das u.a. auch von den Komponenten W und M1 beeinflußt wird, wird durch die im weiteren Verlauf der Sequenz folgenden magnetischen Gradientenfelder dephasiert, so daß zu dem Zeitpunkt, zu dem das von den drei Hochfrequenzimpulsen erzeugte stimulierte Echosignal auftritt, die auf W und M1 zurückzuführenden Anteile des Kernresonanzsignals praktisch verschwunden sind. Man kann statt des ersten Hochfrequenzimpulses auch den zweiten oder den dritten Hochfrequenzimpuls HF2 bzw. HF3 schichtselektiv und die beiden anderen frequenzselektiv machen, doch wird dann das FID-Signal des schichtselektiven Hochfrequenzimpulses weniger stark unterdrückt. Die in Fig. 1 dargestellte Variante mit dem schichtselektiven Hochfrequenzimpuls als ersten der drei Impulse wird daher bevorzugt.

Der zeitliche Abstand zwischen dem ersten Hochfrequenzimpuls HF1 und dem zweiten Hochfrequenzimpuls HF2 beträgt 1/2J, wobei J die skalare Kopplungskonstante von Milchsäure ist (ca. 7Hz), so daß sich ein zeitlicher Abstand von ca. 68 ms ergibt. Dadurch wird erreicht, daß die beiden Frequenzkomponenten, die infolge der J-Kopplung bei der Milchsäurekomponente M2 entstehen, zum Zeitpunkt des zweiten Hochfrequenzimpulses HF2 in Antiphase sind. Das gleiche gilt für die entsprechenden Anteile der Lipidkomponenten L1 und L2, weil deren Kopplungskonstante J etwa genauso groß ist wie die von Milchsäure.

Durch ein zwischen dem ersten und dem zweiten Hochfreimpuls wirksames magnetisches Gradientenfeld Gz3 wird erreicht, daß die Kernmagnetisierung innerhalb der Schicht ortsabhängig (in z-Richtung) variiert. Der zweite Hochfrequenzimpuls bewirkt dabei teilweise die Anregung von höheren Quantenzuständen, die kein beobachtbares Signal liefern und im übrigen den Transfer der Magnetisierung von M2 auf M1. Ebenso wird die Magnetisierung zwischen den Lipidgruppen transferiert. Während dabei der Transfer jedoch wechselseitig ist, ist er zwischen den Milchsäurekomponenten nur einseitig; da die Komponente M1 den zweiten Hochfrequenzimpuls nicht "sieht", erfolgt kein Transfer von M1 nach M2. Infolgedessen ist nach dem zweiten Hochfrequenzimpuls die Magnetisierung bei M2 verschwunden, nicht aber bei L1 und L2. Wenn man auf andere Weise dafür sorgt, daß kein Polarisationstransfer von M1 auf M2 stattfindet, z.B. indem man von vornherein die Komponente M1 zusammen mit der Wasserkomponente W unterdrückt, ist es nicht mehr erforderlich, daß die Hochfrequenzimpulse HF2 und HF3 frequenzselektiv sind. Sie können dann in gleicher Weise schichtselektiv sein wie der erste (HF1).

Nach dem dritten Hochfrequenzimpuls und vor dem Auftreten des stimulierten Echosignals wird ein magnetisches Gradientenfeld Gz5 eingeschaltet, dessen Gradient in der gleichen Richtung verläuft wie der des Feldes Gz3 und dessen Amplitude und Dauer so gewählt sind, daß das zeitliche Integral über Gz3 genauso groß ist wie das über Gz5. Dadurch wird der Einfluß von Gz3 auf das stimulierte Echosignal beseitigt. Das stimulierte Echosignal tritt in einem zeitlichen Abstand von HF3 auf, der dem zeitlichen abstand zwischen HF1 und HF2 entspricht. Während des stimulierten Echosignals ist ein sogenannter Meß- bzw. Lesegradient Gx2 wirksam, dem ein Lesegradient Gx1 zwischen dem ersten und dem zweiten Hochfrequenzimpuls vorausgeht, dessen zeitliches Integral der Hälfte des zeitlichen Integrals über Gx2 entspricht (vergl. 2. Zeile von Fig. 4).

Wie die 5. Zeile von Fig. 2 zeigt, wird während des Auftretens des stimulierten Echosignals der Taktgenerator 16 freigegeben, so daß das stimulierte Echosignal als Folge digitaler Datenworte in den Speicher 14 übernommen wird. Das stimulierte Echosignal wird von allen Komponenten innerhalb des Frequenzbereiches F beeinflußt - mit Ausnahme der Komponente M2.

Diese Sequenz wird nach einer geeigneten Repetitionszeit wiederholt mit dem einzigen Unterschied, daß genau in der Mitte zwischen dem ersten und dem zweiten Hochfrequenzimpuls ein in der ersten Zeile von Fig. 4 gestrichelt angedeuteter 180°-Hochfrequenzimpuls HF4 erzeugt wird, und daß nach dem dritten Hochfrequenzimpuls HF3 ein weiterer 180°-Hochfrequenzimpuls HF5 erzeugt wird, der von HF3 den gleichen Abstand hat wie HF4 von HF1. Diese Impulse sind ebenfalls frequenzselektiv und zwar derart, daß nur eine der Komponenten M1 bzw. M2 angeregt wird. Je nachdem, ob nur eine oder beide Komponenten einer J-Kopplung diese Impulse sehen oder nicht, wird die durch die J-Kopplung bewirkte Modulation refokussiert bzw. nicht refokussiert. Infolgedessen verläuft die Modulation der Komponenten L1 und L2 durch die J-Kopplung in gleicher Weise wie bei der ersten Sequenz (ohne HF4). Hingegen sind die Frequenzkomponenten der Milchsäurekomponente M2 zur Zeit des zweiten Hochfrequenzimpulses HF2 in Phase, tragen also zur Erzeugung eines normalen stimulierten Echos bei.

Wenn dabei nur M2 angeregt wird, beispielsweise wenn HF4 das Spektrum F hat, kann das negative Einflüsse auf das stimulierte Echosignal haben, insbesondere wenn durch Gz3 keine vollständige Rephasierung erreicht wird. In dieser Hinsicht ist ein Frequenzspektrum, das nur die Komponente M1 anregt, nicht aber M2 (und L1, L2), günstiger. Zwar kann sich hierbei u.U. eine zusätzliche unerwünschte Anregung der Wasserkomponente W ergeben; da diese relativ gut zu unterdrücken ist, wird die letztgenannte Variante bevorzugt.

Wie zuvor erläutert, beeinflussen die gekoppelten Lipid-Komponenten L1, L2 und die ungekoppelten Komponenten innerhalb des Bereiches F daher das stimulierte Echosignal bei der zweiten Sequenz in genau der gleichen Weise wie bei der ersten Sequenz; jedoch liefert die Milchsäurekomponente M2 bei der zweiten Sequenz einen Beitrag zum stimulierten Echosignal im Gegensatz zur ersten Sequenz. Subtrahiert man daher die beiden stimulierten Echosignale voneinander, dann wird die Differenz nur noch von der Milchsäurekomponente M2 bestimmt. Es ist daher möglich, die Milchsäureverteilung in der Schicht darzustellen.

Zu diesem Zweck werden die beiden Sequenzen mehrfach wiederholt, wobei jedesmal ein magnetisches Gradientenfeld (Gy, 3. Zeile), das senkrecht zum Lesegradienten (Gx, 2. Zeile) und senkrecht zu dem Schichtselektionsgradienten (Gz, 4. Zeile) verläuft, d.h. in y-Richtung in seiner Amplitude variiert wird. Das Ganze kann dann zur Verbesserung des Signal-Rausch-Verhältnisses noch mehrfach wiederholt werden.

Zur Rekonstruktion der Milchsäureverteilung in der angeregten Schicht gibt es verschiedene Möglichkeiten. Man könnte ein erstes Bild aus den stimulierten Echosignalen der ersten Sequenzen und ein zweites Bild aus den stimulierten Echosignalen der zweiten Sequenzen erzeugen und die beiden Bilder voneinander subtrahieren. Einfacher hinsichtlich des Rechen- und Speicheraufwandes ist es jedoch, die stimulierten Echosignale der ersten und der zweiten Sequenz, die dem gleichen Phasencodierungsgradienten zugeordnet sind, unmittelbar voneinander zu subtrahieren und die so gebildeten Differenzsignale einer zweidimensionalen Fouriertransformation zu unterziehen.

Die schematische Darstellung von Fig. 3 verdeckt, daß im menschlichen Körper die Komponente W dominierend ist, weil die Konzentration der an Wasser gebundenen Protonen um mehrere Zenerpotenzen höher ist als die Konzentration beispielsweise der an die Milchsäurekomponente M2 gebundenen Protonen. Wenn das Frequenzspektrum der frequenzselektiven Impulse HF2 und HF3 nicht dem in Fig. 3 idealisiert dargestellten Spektrum entspricht, sondern so gestaltet ist, daß - wenn auch in stark abgeschwächter Form - auch die Wasserkomponente angeregt werden kann, kann das stimulierte Echosignal wesentlich von dieser Komponente bestimmt werden. Um diese Komponente weitgehend zu unterdrücken, kann vor dem ersten Hochfrequenzimpuls HF1 und/oder zwischen dem zweiten und dem dritten Hochfrequenzimpuls HF2 bzw. HF3 ein auf die Resonanzlinie der Wasserkomponente abgestimmter frequenzselektiver Impuls HF6 bzw. HF7 jeweils gefolgt von einem magnetischen Gradientenfeld (Gz1 bzw. Gz4) erzeugt werden, das die dadurch angeregten Wasserkomponenten dephasiert, so daß deren Einfluß auf das stimulierte Echosignal stark herabgesetzt wird.

Im Ausführungsbeispiel sind die frequenzselektiven Hochfrequenzimpulse HF6 und HF7 sogenannte binomiale Hochfrequenzimpulse, die aus mehreren Teilpulsen bestehen, deren Amplituden im gleichen Verhältnis zueinander stehen wie die Binomialkoeffizienten und deren zeitliche Abstände bzw. deren Mittenfrequenz im Hinblick auf die Anregung der Wasserkomponente optimiert sind. Es können jedoch auch andere Impulse benutzt werden, z.B. sogenannte DANTE-Impulse.

Wenn die Wasserkomponente W unterdrückt ist, ist in der Regel auch die Milchsäurekomponente M1 unterdrückt. Da dann ein Polarisationstransfer zwischen M1 und M2 nicht mehr möglich ist, müssen in diesem Fall die Hochfrequenzimpulse HF2 und HF3 nicht frequenzselektiv sein. Sie können also auch breitbandiger sein. Um die Signalverarbeitung zu erleichtern, sollten sie dann aber in gleicher Weise schichtselektiv sein wie HF1; d.h. in ihrer Anwesenheit müßte ein in z-Richtung verlaufendes magnetisches Gradientenfeld (wie Gz2) erzeugt werden.

## Ansprüche

1. Kernresonanz-Abbildungsverfahren, bei dem in Anwesenheit eines homogenen stationären Magnetfeldes folgende Schritte durchgeführt werden:

   a) Erzeugung einer ersten Sequenz mit drei Hochfrequenzimpulsen, von denen mindestens einer (HF1) schichtselektiv ist, wobei zwischen dem ersten und dem zweiten Hochfrequenzimpuls (HF2) sowie nach dem dritten Hochfrequenzimpuls (HF3) und vor der Erfassung des Kernresonanzsignals ein magnetisches Gradientenfeld (Gz3 bzw.. Gz5) mit jeweils dem gleichen zeitlichen Integral wirksam wird und wobei der zeitliche Abstand zwischen dem ersten und dem zweiten Hochfrequenzimpuls 1/2 J ist, wobei J die Kopplungskonstante von Milchsäure ist,

   b) Erzeugung einer zweiten Sequenz, die sich von der ersten nur dadurch unterscheidet, daß zusätzlich zwei 180°-Hochfrequenzimpulse (HF4, HF5) im jeweils gleichen Abstand von dem ersten bzw. dem dritten Hochfrequenzimpuls (HF1 bzw. HF3) erzeugt werden, wobei der eine 180°-Hochfrequenzimpuls in der Mitte zwischen dem ersten (HF1) und dem zweiten Hochfrequenzimpuls (HF2) liegt und wobei beide 180°-Hochfrequenzimpulse (HF4, HF5) derart frequenzselektiv sind, daß nur die eine der beiden gekoppelten Milchsäurekomponenten (M1 oder M2) angeregt wird,

   c) Erfassung der bei jeder Sequenz auftretenden stimulierten Echosignale

   d) Wiederholung der Schritte a) bis c) unter Variation wenigstens eines magnetischen Gradientenfeldes Gy nach Größe und/oder Richtung

   e) Bildung der Differenz zwischen den stimulierten Echo signalen und der ersten und der zweiten Sequenzen

   f) Rekonstruktion der Milchsäureverteilugn in der angeregten Schicht aus den Differenzen.

2. Verfahren nach Anspruch 1, **dadurch gekennzeichnet,** daß von den drei Hochfrequenzimpulsen der erste (HF1) schichtselektiv und die beiden folgenden (HF2 und HF3) frequenzselektiv sind.

3. Verfahren nach Anspruch 1, **dadurch gekennzeichnet,** daß die beiden 180°-Hochfrequenzimpulse (HF4, HF5) von den gekoppelten Milchsäurekomponenten (M1,M2) nur die der Wasserkomponente (W) benachbarte (M1) Komponente angeregt wird.

4. Verfahren nach Anspruch 1 oder 2, **dadurch gekennzeichnet,** daß in jeder Sequenz vor dem ersten und/oder zwischen dem zweiten und dem dritten Hochfrequenzimpuls ein selektiv nur die an Wasser gebundenen Protonen anregender Hochfrequenzimpuls (HF5 bzw. HF6), gefolgt von einem der Dephasierung dienenden magnetischen magnetischen Gradientenfeld (Gz1 bzw. Gz4), erzeugt wird.

5. Verfahren nach Anspruch 2, **dadurch gekennzeichnet,** daß die Mittenfrequenz der frequenzselektiven Impulse (HF2, HF3) unterhalb der Larmorfrequenzen der gekoppelten Lipid- und Milchsäurekomponenten liegt.

6. Anordnung zur Durchführung des Verfahrens nach Anspruch 1 mit einem Magneten zur Erzeugung eines homogenen stationären Magnetfeldes und mit Mitteln zum Wiederholen und Erzeugen der ersten und der zweiten Sequenz, mit Mitteln zum Erfassen der bei den einzelnen Sequenzen erzeugten stimulierten Echosignale, mit Mitteln zur Bildung der Differenz der stimulierten Echosignale und zur Rekonstrukton der Milchsäureverteilung aus den Differenzen.

Fig.1

Fig.2

Fig.3

Fig.4